# EUROPÄISCHE PATENTSCHRIFT

(11) **EP 0 576 918 B1**
(45) Veröffentlichungstag und Bekanntmachung des Hinweises auf die Patenterteilung: **22.04.1998**
(21) Anmeldenummer: 93109631.7
(22) Anmeldetag: 16.06.1993
(51) Int. Cl.: G06K 7/10, G06K 7/08

(54) **Vorrichtung zur Datenspeicherung**
Data storage apparatus
Dispositif de mémorisation de données

(30) Priorität: 30.06.1992 DE 9208724 U
(43) Veröffentlichungstag der Anmeldung: 05.01.1994
(73) Patentinhaber: SIEMENS AKTIENGESELLSCHAFT, 80333 München (DE)
(72) Erfinder: Meyer, Heinrich, Dipl.-Ing. FH, D-8500 Nürnberg 50 (DE)

(56) Entgegenhaltungen:
- EP-A- 0 161 779
- EP-A- 0 281 470
- PATENT ABSTRACTS OF JAPAN vol. 9, no. 4 (E-288)10. Januar 1985 & JP-A-59 154 844

## Beschreibung

Die Erfindung bezieht sich auf eine Vorrichtung zur Datenspeicherung mit einer Schreib-Leseeinheit und einer mobilen Datenträgereinheit, wobei beide Einheiten Sende- und Empfangseinrichtungen aufweisen und wobei die von einer Einheit gesendeten Informationen sowohl von der jeweils anderen Einheit als auch von der Empfangseinrichtung der sendenden Einheit empfangen und senderseitig mit den gesendeten Informationen verglichen werden.

Eine solche Vorrichtung ist aus der EP-A-O 161 779 bekannt. Störungen werden dabei dadurch erkannt, daß beispielsweise die von einer Basisstation zu einem Transponder gesendeten Daten von letzterem zurückgesendet und in einer Basisstation mit den ursprünglich gesendeten Daten verglichen werden. Ein ähnlicher Sachverhalt findet sich auch bei der JP-A-59 154 844.

Zur Identifizierung und Bearbeitung von beliebigen Gegenständen, beispielsweise von Werkstücken oder Teilprodukten in Produktionslinien, wird dem jeweiligen Gegenstand ein sogenannter mobiler Datenträger zugeordnet. Dieser mobile Datenträger verfügt unter anderem über eine Speichervorrichtung in der alle den Gegenstand betreffenden produktionsrelevanten Daten hinterlegt sind oder nach Abschluß bestimmter Bearbeitungsvorgänge neu hinterlegt werden können. Die Änderung der Daten im Speicher des mobilen Datenträgers erfolgt über Schreib-Lese-Geräte, die an den verschiedensten Stellen einer Produktionslinie vorgesehen sind, durch drehtlose Übertragung.

Die Bereiche, an denen die mobilen Datenspeicher vom Schreib-Lese-Gerät bearbeitet werden sollen, sind jedoch häufig Störeinflüssen ausgesetzt, die die Übertragungsstrecke beeinflussen und zu Fehldaten im Schreib-Lese-Speicher führen. Diese Fehler können den Bearbeitungsablauf des jewieligen Gegenstandes oder eine ganze Produktionslinie stoppen oder zu falschen Bearbeitungsvorgängen führen.

Es ist daher Aufgabe der Erfindung, ein Identifikationssystem zu schaffen, mit dem Störungen die den Übertragungsweg beeinflussen, erkannt werden.

Diese Aufgabe wird für eine Vorrichtung der eingangs genannten Art dadurch gelöst, daß die Empfangseinrichtung der jeweils sendenden Einheit so ausgelegt ist, daß sie direkt die von ihrer Sendeantenne ausgestrahlten Informationen empfängt und diese mit der Sendeinformation vergleicht.

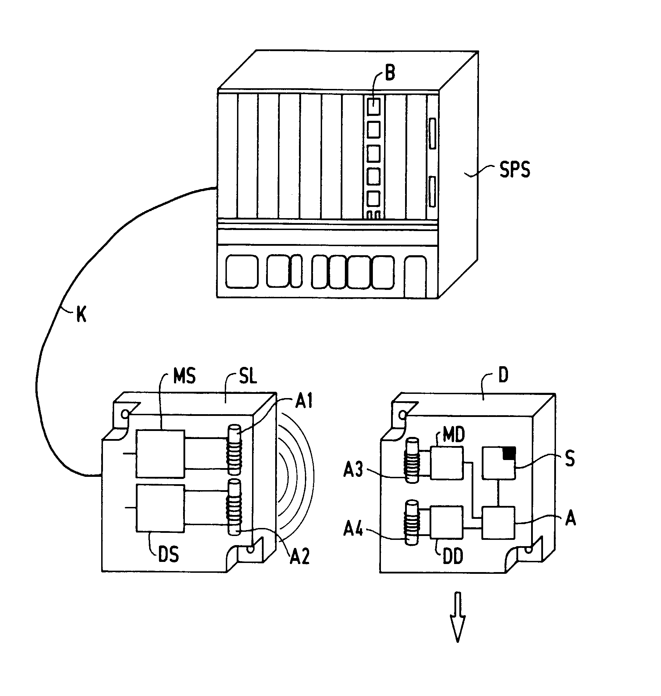

Ein Ausführungsbeispiel der Erfindung wird im folgenden anhand der Zeichnung näher beschrieben.

Die Figur zeigt ein Automatisierungsgerät SPS, wie es beispielsweise bei speicherprogrammierbaren Steuerungen verwendet wird. Das Automatisierungsgerät SPS ist über ein Kabel K mit einem Schreib-Lese-Gerät SL verbunden. Neben dem Schreib-Lese-Gerät SL ist ein mobiler Datenträger D gezeigt, der stationär einem nicht gezeigten Werkstück zugeordnet oder an einer Palette angebracht ist und der - wie durch den Pfeil angedeutet - am Schreib-Lese-Gerät SL vorbeigeführt wird.

Das Automatisierungsgerät SPS verfügt unter anderem über eine Steuerbaugruppe B, die für den Informationsaustausch mit der Schreib-Lese-Vorrichtung SL zuständig ist. Die Schreib-Lese-Vorrichtung SL weist einen Modulator MS und eine daran angeschlossene Sendeantenne A1 sowie einen Demodulator DS und eine daran angeschlossene Empfangsantenne A2 auf. Der mobile Datenträger D verfügt ebenfalls über einen Modulator MD und eine diesem zugeordnete Antenne A3 sowie über einen Demodulator DD und eine diesem zugeordnete Antenne A4. Der Modulator MD, der Demodulator DD sowie ein Schreib-Lese-Speicher S sind an eine Steuereinheit A, die als ASIC ausgeführt sein kann, angeschlossen. Über die Steuereinheit A kann der Schreib-Lese-Speicher S beschrieben und gelesen werden; außerdem steuert sie die Sende- und Empfangsvorgänge über die Antennen A3 und A4.

Über das Automatisierungsgerät SPS werden die produktionsrelevanten Daten für ein jeweiliges Werkstück an das Schreib-Lese-Gerät SL gegeben. Soll der Speicher S des mobilen Datenspeichers D ganz oder teilweise neu beschrieben werden, so werden die entsprechenden Befehle und Daten vom Automatisierungsgerät SPS über den Modulator MS und die Antenne Al des Schreib-Lese-Gerätes SL an den mobilen Datenspeicher D gesendet. Dieser empfängt mit seiner Antenne A4 die Informationen und gibt sie über den Demodulator DD und die interne Steuereinheit A an den Speicher S weiter. Gleichzeitig werden die vom Schreib-Lese-Gerät SL über die Antenne Al gesendeten Informationen mit der Antenne A2 des Schreib-Lese-Gerätes empfangen und über den Demodulator DS dem Automatisierungsgerät SPS zugeleitet. In der Steuerbaugruppe B werden dann die empfangenen mit den gesendeten Daten verglichen. Sobald sich sendeseitig eine Abweichung der Empfangs- und Sendedaten ergibt, werden vom Automatisierungsgerät SPS Fehlerroutinen eingeleitet. Dabei kann die Übertragung sofort abgebrochen und neu begonnen werden und dem Anwender ein Fehler gemeldet werden. Auch wenn beispielsweise vom Schreib-Lese-Gerät SL ohne daß ein Informationsaustausch zum Datenträger D stattfindet, Feldstörungen über die Antenne A2 detektiert werden, kann eine vorgesehene Datenübertragung solange ausgesetzt werden, bis keine Feldstörungen mehr zu erkennen sind.

Der mobile Datenträger D ist ebenso wie das Schreib-Lese-Gerät SL mit einer Sende- A3 und Empfangsantenne A4 ausgestattet und kann auf diese Weise wie das Schreib-Lese-Gerät die gesendeten Daten selbst empfangen und in seiner internen Steuereinheit A vergleichen.

Mit der Vorrichtung ist nicht nur ein sicherer Informationsaustausch zwischen Schreib-Lese-Gerät SL und mobilen Datenträger gewährleistet, sondern es führen durch den permanenten Mithörempfang über die Empfangsantenne A2 (und wahlweise zusätzlich über die Empfangsantenne A4), auch Kabelbrüche auf der Leitung zwischen Automatisierungsgerät SPS und Schreib-Lese-Gerät SL, sowie eine abgeschaltete Versorgungsspannung des Schreib-Lese-Geräts SL und Störfelder auf der induktiven Übertragungsstrecke zu Fehlermeldungen. Darüber hinaus sorgt der Mithörempfang gleichzeitig für einen permanenten Funktionstest sowohl der kompletten im Schreib-Lese-Gerät SL untergebrachten Hardware und der Hardware im mobilen Datenspeicher D durch die dort untergebrachte Steuereinheit A.

## Patentansprüche

1. Vorrichtung zur Datenspeicherung mit einer Schreib-Leseeinheit (S) und einer mobilen Datenträgereinheit (D), wobei beide Einheiten (S,D) Sende- (MS,A1;MD,A3) und Empfangseinrichtungen (DS,A2;DD,A4) aufweisen und wobei die von einer Einheit (S,D) gesendeten Informationen sowohl von der jeweils anderen Einheit (D,S) als auch von der Empfangseinrichtung (2,DS;A4,DD) der sendenden Einheit (D,S) empfangen und senderseitig mit den gesendeten Informationen verglichen werden, **dadurch gekennzeichnet**, daß die Empfangseinrichtung (DS,A2;DD,A4) der jeweils sendenden Einheit (S,D) so ausgelegt ist, daß sie direkt die von ihrer Sendeantenne (A2,A4) ausgestrahlten Informationen empfängt und diese mit der Sendeinformation vergleicht.

## Claims

1. Device for data storage, having a read-write unit (S) and a mobile data carrier unit (D), with both units (S, D) having transmitting devices (MS, A1; MD, A3) and receiving devices (DS, A2; DD, A4) and with the items of information transmitted by one unit (S, D) being received both by the respective other unit (D, S) and by the receiving device (2(sic), DS; A4, DD) of the transmitting unit (D, S) and being compared on the transmitter side with the items of information that were transmitted, characterised in that the receiving device (DS, A2; DD, A4) of the unit (S, D) which transmits in each case is designed in such a way that it receives directly the items of information which are emitted by its transmitting antenna (A2, A4) and compares them with the transmitted information.

## Revendications

1. Dispositif de mémorisation de données comportant une unité (S) d'écriture-lecture et une unité (D) de support de données mobile, les deux unités (S,D) comportant des dispositifs (MS,A1;MD,A3) d'émission et des dispositifs (DS,A2;DD,A4) de réception et les informations émises par l'une des unités (S,D) étant reçues aussi bien par l'autre unité (D,S) associée que, également, par le dispositif (A2, DS;A4,DD) de réception de l'unité (D,S) émettrice et, du côté émetteur, comparées aux informations émises, caractérisé en ce que le dispositif (DS,A2;DD,A4) de réception de l'unité (S,D) émettrice est conçu de telle manière qu'elle reçoit directement les informations émises par son antenne (A2,A4) émettrice et les compare aux informations émises.
